# EUROPÄISCHE PATENTANMELDUNG

(11) **EP 4 844 887 A1**
(43) Veröffentlichungstag der Anmeldung: **25.11.2026**
(21) Anmeldenummer: 26178225.4
(22) Anmeldetag: 12.05.2026
(51) Int. Cl.: H01M 10/42, G01R 31/36, H01M 10/48

(54) **ZELLHALTER UND AUFNAHMEVORRICHTUNG FÜR EINEN ZELLHALTER**

(30) Priorität: 20.05.2025 DE 102025119593
(71) Anmelder: Zentrum für Sonnenenergie- und Wasserstoff-Forschung Baden-Württemberg (ZSW), 70563 Stuttgart (DE)
(72) Erfinder: FRANKL, Sebastian Dominic, 89075 Ulm (DE)
(74) Vertreter: Lorenz Seidler Gossel Part. mbB

(57) **Zusammenfassung**

Die vorliegende Erfindung betrifft einen Zellhalter (10) zum lösbaren Halten einer, vorzugsweise einer einzigen, Batteriezelle (B), vorzugsweise einer Rundzelle, wobei der Zellhalter (10) einen Grundkörper (12) aufweist sowie einen Aufnahmeabschnitt (14) für die Batteriezelle (B), wobei der Zellhalter (10) des Weiteren einen oder mehrere erste Kontakte (K1) aufweist, die derart angeordnet sind, dass diese bei einer in dem Aufnahmeabschnitt (14) befindlichen Batteriezelle (B) mit einem oder mehreren zweiten Kontakten der Batteriezelle (B) in elektrisch leitenden Kontakt gebracht werden können, wobei der Aufnahmeabschnitt (14) in einer oder mehreren Dimensionen derart veränderbar ausgebildet ist, dass in dem Aufnahmeabschnitt (14) des Zellhalters (10) Batteriezellen (B) mindestens zweier unterschiedlicher Größen kontaktierend aufnehmbar sind.

## Beschreibung

Die vorliegende Erfindung betrifft einen Zellhalter zum lösbaren Halten einer Batteriezelle, eine Aufnahmevorrichtung für einen Zellhalter, ein System aus einem Zellhalter und einer Aufnahmevorrichtung für einen Zellhalter, ein Verfahren zum Testen mindestens einer Batteriezelle und eine Verwendung eines Zellhalters.

Zum Testen von Batteriezellen werden gemäß dem Stand der Technik Zellhalter verwendet, in denen eine Batteriezelle lösbar gehalten werden kann.

Die Kontaktierung der Batteriezelle erfolgt in solchen bekannten Zellhaltern bspw. über eine Verschraubung, die mittels eines Schraubenziehers oder über eine Rändelschraube bestätigt wird, wobei ein Bediener des Zellhalters zeitgleich den Zellhalter zusammenpresst, um die Kontaktierung herzustellen. Das Verschrauben dauert sehr lange, ist mühselig und es ist kein definierter Anpressdruck einstellbar. Außerdem ist es möglich, dass sich die Verschraubung des Zellhalters nach einiger Zeit ungewollt löst. Die Sicherheit der Kontaktierung der Batteriezelle ist damit nicht gewährleitet.

Ein solcher aus dem Stand der Technik bekannter Zellhalter ist üblicherweise groß dimensioniert und benötigt viel Platz.

Eine Modularität eines solchen bekannten Zellhalters ist nur durch aufwändiges Auseinanderbauen des bekannten Zellhalters gegeben.

Solche aus dem Stand der Technik bekannten Zellhalter sind nicht stapelbar.

An solchen aus dem Stand der Technik bekannten Zellhaltern können nicht viele elektrische Leitungen angeschlossen werden, wenn nicht genügend Platz nach oben vorhanden ist, da die Kontakte in solchen bekannten Zellhaltern meist nach oben ausgerichtet sind.

Ebenso ist an solchen bekannten Zellhaltern keine Kennzeichnung, die insbesondere kennzeichnet welche Batteriezellen in den Zellhalter eingesetzt werden können, vorhanden.

Vor diesem Hintergrund liegt der vorliegenden Erfindung die Aufgabe zugrunde, einen oben genannten Zellhalter zum lösbaren Halten einer Batteriezelle zu verbessern und einen solchen Zellhalter sowie eine Aufnahmevorrichtung für einen solchen Zellhalter, ein System aus einem solchen Zellhalter und einer solchen Aufnahmevorrichtung, ein Verfahren zum Testen mindestens einer Batteriezelle und eine Verwendung eines solchen Zellhalters bereitzustellen, wobei die Nachteile des Stands der Technik abgemildert oder gar gänzlich beseitigt sind und insbesondere ein schnelles und sicheres Kontaktieren einer Batteriezelle möglich ist.

Diese Aufgabe wird durch den Gegenstand mit den Merkmalen des unabhängigen Anspruchs 1, durch das Verfahren des unabhängigen Anspruchs 22 und die Verwendung des unabhängigen Anspruchs 24 gelöst. Vorteilhafte Weiterbildungen der Erfindung sind Gegenstand der abhängigen Ansprüche.

Demnach ist erfindungsgemäß vorgesehen: Ein Zellhalter zum lösbaren Halten einer, vorzugsweise einer einzigen, Batteriezelle, vorzugsweise einer Rundzelle, wobei der Zellhalter einen Grundkörper aufweist sowie einen Aufnahmeabschnitt für die Batteriezelle, wobei der Zellhalter des Weiteren einen oder mehrere erste Kontakte aufweist, die derart angeordnet sind, dass diese bei einer in dem Aufnahmeabschnitt befindlichen Batteriezelle mit einem oder mehreren zweiten Kontakten der Batteriezelle in elektrisch leitenden Kontakt gebracht werden können, wobei der Aufnahmeabschnitt in einer oder mehreren Dimensionen derart veränderbar ausgebildet ist, dass in dem Aufnahmeabschnitt des Zellhalters Batteriezellen mindestens zweier unterschiedlicher Größen kontaktierend aufnehmbar sind.

Der Aufnahmeabschnitt dient vorzugsweise als austauschbare Führung und/oder Halterung für verschiedene Formate und/oder Typen von Batteriezellen.

Vorzugsweise ist die Batteriezelle schnell und/oder eine Batteriezelle separat aus dem Zellhalter entnehmbar und nicht dauerhaft mit dem Zellhalter verbunden.

Vorzugsweise ist vorgesehen, dass mehrere erste Kontakte vorhanden sind, von denen zumindest einer zur Spannungsversorgung ausgebildet ist, und von denen zumindest ein weiterer, von dem Kontakt zur Spannungsversorgung getrennter Kontakt zur Messung zumindest eines Parameters, vorzugsweise zur Spannungsmessung ausgebildet ist, wobei vorzugsweise vorgesehen ist, dass die Anzahl der zur Spannungsversorgung ausgebildeten Kontakte größer ist als die Anzahl der zur Messung ausgebildeten Kontakte.

Die ersten Kontakte sind vorzugsweise federnd ausgebildet. Die ersten Kontakte können Federkontakte sein.

Vorzugsweise erfolgt eine mechanische Einspannung der Batteriezelle unter anderem durch Federkraft der ersten Kontakte und/oder ein elektrischer Kontakt über leitfähige erste Kontakte.

Vorzugsweise ist vorgesehen, dass der Zellhalter derart ausgelegt ist, dass in dem Zellhalter Batteriezellen des Typs 18650 oder 21700 kontaktierend aufnehmbar sind und/oder dass der Zellhalter, vorzugsweise dessen Aufnahmeabschnitt, eine Kennzeichnung aufweist, die die Batteriezelle und/oder den Zellhalter, insbesondere dessen Aufnahmeabschnitt, und/oder eine Messapparatur zur Messung der in dem Zellhalter befindlichen Batteriezelle kennzeichnet und/oder eine Zuordnung zwischen Batteriezelle und/oder Zellhalter, insbesondere dessen Aufnahmeabschnitt, und/oder Messapparatur aufweist.

Vorzugsweise erfolgt eine Kennzeichnung des für die jeweilige Zellhalterkonfiguration geeigneten Typs oder Formats von Batteriezelle auf dem Zellhalter, insbesondere auf dem Aufnahmeabschnitt.

Vorzugsweise ist an einer insbesondere schmalen Seite des Zellhalters ein Plakettenabschnitt, insbesondere mit vier kreisrunden Aussparungen vorhanden. An dem Plakettenabschnitt kann eine Plakette, bspw. in Form eines Plastikschildchens angebracht, bspw. aufgeklickt werden, auf welchem bspw. eine Zellnummer steht.

Der Zellhalter ist vorzugsweise für Rundzellen ausgebildet. Die Batteriezelle ist vorzugsweise eine Rundzelle. Der Zellhalter kann vorzugsweise, insbesondere durch Austausch des Aufnahmeabschnitts Batteriezellen vom Typ 18650 und 21700 aufnehmen. Vorzugsweise kann der Zellhalter genau eine Batteriezelle aufnehmen.

Vorzugsweise kann der Zellhalter derart konfiguriert werden, dass die gängigsten Zellformate für Rundzellen der Typen 18650 und 21700 jeweils einzeln in dem Zellhalter sicher, schnell und platzsparend untergebracht und dabei gleichzeitig kontaktiert werden können, insbesondere sodass ein Messaufbau zur Zyklisierung für Batterietests in Testlaboren schnell aufgebaut ist.

Vorzugsweise ist vorgesehen, dass der Aufnahmeabschnitt eine vorzugsweise wannenförmige, wellenförmige oder stegförmige Vertiefung oder sonstige Ablage aufweist oder umfasst, in welche die Batteriezelle einlegbar ist, wobei der Aufnahmeabschnitt relativ zu dem Grundkörper modular und / oder auswechselbar ausgestaltet ist, und/oder wobei vorzugsweise vorgesehen ist, dass die Vertiefung eine zu der Außenseite der Batteriezelle komplementäre Form aufweist.

Der Zellhalter ist vorzugsweise modular aufgebaut. Der Zellhalter kann, insbesondere durch Austausch des Aufnahmeabschnitts, sowohl Batteriezellen des Typs oder Formats 18650 als auch des Typs oder Formats 21700 aufnehmen. Der Umbau des Zellhalters, insbesondere durch Austausch des Aufnahmeabschnitts, von einem Typ oder Format auf das andere ist vorzugsweise in wenigen Sekunden möglich.

Vorzugsweise ist eine hohe Modularität des Zellhalters vorhanden. Der austauschbare Aufnahmeabschnitt des Zellhalters und die einzelne Bestückung der Aufnahmevorrichtung bieten vorzugsweise hohe Flexibilität hinsichtlich Zellformat und Anzahl der Testkanäle.

Die Batteriezelle liegt vorzugsweise in dem Aufnahmeabschnitt und wird vorzugsweise zu ca. 1/3 von dem Aufnahmeabschnitt bedeckt. Vorzugsweise können somit 2/3 der Batteriezelle durch Konvektion gekühlt werden.

Vorzugsweise ist ein schneller Austausch des Aufnahmeabschnitts möglich. Vorzugsweise bedingt dies den Vorteil eines schnellen Wechsels zwischen verschiedenen Formaten und/oder Typen von Batteriezellen.

Vorzugsweise ist vorgesehen, dass die Vertiefung oder sonstige Ablage eine oder mehrere Aussparungen aufweist, insbesondere zum Zwecke der Wärmeabfuhr und/oder zur Platzierung von funktionalen Elementen, wie vorzugsweise Sensoren, an oder in der Vertiefung oder der sonstigen Ablage.

Der Zellhalter weist vorzugsweise ein offenes Design auf. Der Zellhalter ist vorzugsweise derart ausgebildet und/oder die Batteriezelle ist vorzugsweise derart in dem Zellhalter angeordnet, dass genügend Oberfläche der Batteriezelle nicht bedeckt wird, sodass ein guter Wärmestrom von der Batteriezelle in die umgebende Luft durch Konvektion ermöglicht wird. Der Zellhalter ist vorzugsweise derart ausgebildet und/oder die Batteriezelle ist vorzugsweise derart in dem Zellhalter angeordnet, dass Sensoren wie Dehnungsmesstreifen und/oder Temperatursensoren an der Oberfläche der Batteriezelle angebracht werden können.

Die Batteriezelle ist vorzugsweise beidseitig aufgrund der Einspannung begrenzt. Die Batteriezelle liegt vorzugsweise auf dem Aufnahmeabschnitt und wird von unten bspw. mit einem Winkel von 120° zu 1/3 abgedeckt. Der übrige Bereich der Oberfläche der Batteriezelle ist vorzugsweise frei und erlaubt eine gute Kühlanbindung sowie Platz für Sensoren.

Das Anbringen von Temperatursensoren an den eingespannten Batteriezellen kann vorzugsweise schnell und einfach erfolgen.

Vorzugsweise ist vorgesehen, dass der Zellhalter einen relativ zu dem Grundkörper bewegbaren Verfahrschlitten aufweist, welcher dazu ausgelegt ist, eine in dem Zellhalter aufgenommene Batteriezelle lösbar in dem Zellhalter zu fixieren und / oder in diesem einzuspannen.

Vorzugsweise ist vorgesehen, dass der Aufnahmeabschnitt einen Bestandteil des Verfahrschlittens bildet oder lösbar mit dem Verfahrschlitten in Verbindung steht und mit diesem bewegbar ist und/oder dass der Aufnahmeabschnitt zwischen einen Teil des Grundkörpers und einem Teil des Verfahrschlittens angeordnet ist.

Vorzugsweise ist vorgesehen, dass der Zellhalter des Weiteren eine Arretierungseinheit aufweist, vorzugsweise in Form mindestens eines Formschlusselements, mittels welcher der Verfahrschlitten relativ zu dem Grundkörper in einer gewünschten Relativposition zwischen dem Verfahrschlitten und dem Grundkörper arretierbar ist.

Vorzugsweise ist vorgesehen, dass die Arretierungseinheit einen oder mehrere vorzugsweise vorgespannte Vorsprünge, vorzugsweise Haken sowie mehrere in Verfahrrichtung des Verfahrschlittens voneinander beabstandete Aufnahmebereiche für den oder die Vorsprünge aufweist, wobei vorzugsweise vorgesehen ist, dass der oder die Vorsprünge relativ zu den Aufnahmebereichen verschwenkbar sind und/oder an dem Grundkörper angeordnet sind.

Die Arretierungseinheit weist vorzugsweise einen Hebel-Mechanismus zur sicheren Einspannung der Batteriezelle auf. Vorzugsweise erfolgt eine sichere Kontaktierung der Batteriezelle in dem Zellhalter.

Die Aufnahmebereiche sind vorzugsweise Bestandteil eines Aufnahmeelements.

Die Arretierungseinheit weist vorzugsweise zwei Einrastpositionen auf.

Diese zwei Einrastpositionen und das Auswechseln des Aufnahmeabschnitts erlauben die Anordnung von Batteriezellen des Typs 18650 und 21700. Der Einbau der Batteriezelle ist vorzugsweise schnell, sicher und einfach zu erledigen.

Vorzugsweise ist vorgesehen, dass der Zellhalter des Weiteren eine Freigabeeinheit aufweist, mittels welcher eine durch die Arretierungseinheit bedingte Arretierung des Verfahrschlittens relativ zu dem Grundkörper lösbar ist, wobei die Freigabeeinheit vorzugsweise wenigstens ein relativ zu dem Grundkörper bewegliches Betätigungselement aufweist, das vorzugsweise als Hebel ausgeführt ist.

Die Arretierungseinheit dient vorzugsweise als Schnellverschluss-Mechanismus zur schnellen und sicheren Fixierung der Batteriezelle im Zellhalter und zum schnellen Herausnehmen durch einfaches Betätigen der Freigabeeinheit, insbesondere des Betätigungselements, vorzugsweise in Form eines Hebels, und Herausnehmen der Batteriezelle.

Vorzugsweise ist vorgesehen, dass die Arretierungseinheit durch Betätigung eines einfachen Hebels geöffnet werden können. Dies ermöglicht vorzugsweise schnelles Einspannen und Entfernen einer Batteriezelle, die getestet werden soll. Außerdem ist der Hebel der Arretierungseinheit vorzugsweise geschützt, wenn der Zellhalter in einer Aufnahmevorrichtung befestigt ist, sodass versehentliches Öffnen des Zellhalters in der Aufnahmevorrichtung nicht möglich ist.

Vorzugsweise ist vorgesehen, dass der oder die Vorsprünge an dem Betätigungselement angeordnet sind.

Vorzugsweise ist vorgesehen, dass der Zellhalter des Weiteren eine Verankerungseinheit aufweist, welche vorzugsweise einen Vorsprung aufweist und welche dazu ausgelegt ist, den Zellhalter vorzugsweise mittels einer formschlüssigen Verbindung lösbar an einer Aufnahmevorrichtung, vorzugsweise an einem Gestell für den Zellhalter, zu verankern, wobei die Verankerungseinheit dazu ausgelegt ist, mit einem Haltemittel, vorzugsweise mit einer Schiene der Aufnahmevorrichtung lösbar zusammenzuwirken.

Vorzugsweise ist vorgesehen, dass die Verankerungseinheit weiterhin eine Löseeinheit aufweist, welche dazu ausgelegt ist, eine Verankerung des Zellhalters an dem Haltemittel durch die Verankerungseinheit bei einer Betätigung eines vorzugsweise vorgespannten Betätigungselements der Löseeinheit zu lösen, wobei das Betätigungselement ein vorzugsweise in Vertikalrichtung beweglicher Hebel oder Schieber ist.

Vorzugsweise ist vorgesehen, dass die Verankerungseinheit derart ausgebildet ist, dass eine Verankerung des Zellhalters an dem Haltemittel durch die Verankerungseinheit ausschließlich durch eine Betätigung des Betätigungselements der Löseeinheit lösbar ist.

Die Verankerungseinheit dient vorzugsweise als Schnellverschluss-Mechanismus zur schnellen und sicheren Fixierung des Zellhalters in der Aufnahmevorrichtung und zum schnellen Herausnehmen durch einfaches Betätigen der Löseeinheit, insbesondere des Betätigungselements, vorzugsweise in Form eines Hebels oder Schiebers und/oder Herausziehen des Zellhalters aus der Aufnahmevorrichtung.

Der Zellhalter weist vorzugsweise ein oder mehrere standardisierte Bauteile, bspw. ein Standard-Konstruktionsprofil und/oder ein oder mehrere Laborsteckbuchsen auf.

Der Zellhalter weist vorzugsweise möglichst viele standardisierte, kommerziell erhältliche Bauteile auf, insbesondere sodass wenige Bauteile des Zellhalters speziell für den Zellhalter angefertigt sind.

Vorzugsweise erfolgt eine Verwendung standardisierter Bauteile. Der Grundkörper, auf dem alle 3D-gedruckten Bauelemente montiert sind, ist vorzugsweise ein Strangpress-Aluminiumprofil, bspw. mit einer Kantenlänge von 3 cm. Außerdem sind die gefederten Kontakte bzw. Pins sowie die Laborsteckbuchsen, Leitungen und alle Federn, Schrauben, Muttern und Beilagscheiben des Zellhalters vorzugsweise Standardbauteile.

Der Zellhalter kann in Teilen additiv, also mittels 3D-Druck gefertigt sein. Geeignet für die additive Herstellung im 3D-Druck sind für die Zellhalter beispielsweise eines oder mehrere der folgenden Materialien: ABS (Acrylnitril-Butadien-Styrol-Copolymer) und ASA (Acrylnitril-Styrol-Acrylat-Copolymer), insbesondere aufgrund der der hohen Temperaturstabilität bis 110°C. Weniger geeignet aber grundsätzlich denkbar ist auch die Verwendung von PLA (Polylactid) und/oder PETG (Glykolmodifiziertes Polyethylenterephthalat), da diese eine geringe Temperaturstabilität nur bis 60°C aufweisen.

Die Erfindung betrifft auch eine Aufnahmevorrichtung, vorzugsweise Gestell, für mindestens einen erfindungsgemäßen Zellhalter, mit einem Grundgestell und mindestens einem Auflageboden oder Träger, an welchem mindestens ein Haltemittel, vorzugsweise mindestens eine Schiene angeordnet ist, die zur lösbaren Verankerung des mindestens eines Zellhalters an der Aufnahmevorrichtung ausgebildet ist.

Vorzugsweise ist vorgesehen, dass mehrere Auflageböden oder Träger nebeneinander und/oder in zwei oder mehr als zwei Ebenen oder versetzt übereinander angeordnet sind.

Vorzugsweise ist vorgesehen, dass das mindestens eine Haltemittel mindestens ein Formschlusselement, vorzugsweise eine Vertiefung, aufweist, welches dazu ausgelegt ist, mit einer Verankerungseinheit eines an dem Haltemittel verankerten Zellhalters lösbar zusammenzuwirken.

Vorzugsweise ist vorgesehen, dass auf dem mindestens einen Auflageboden oder Träger eine Mehrzahl an Haltemitteln nebeneinander angeordnet sind, wobei es sich bei den Haltemitteln vorzugsweise um Schienen handelt, die parallel oder im Wesentlichen parallel zueinander angeordnet sind, wobei vorzugsweise vorgesehen ist, dass die Formschlusselemente der Schienen zu einer gemeinsamen Seite des Auflagebodens oder Trägers ausgerichtet sind.

Mehrere Zellhalter können übereinander stapelbar sein, wobei jeder Zellhalter aus der Stapelanordnung einzeln herausgenommen werden kann, ohne die anderen Zellhalter zu beeinflussen.

Mehrere Zellhalter sind vorzugsweise stapelbar. Mehrere Zellhalter können vorzugsweise einzeln in die Aufnahmevorrichtung, insbesondere in Form eines Gestells, eingesetzt werden, wobei die einzelnen Zellhalter nicht miteinander interagieren, sodass das Herausnahmen und das Hinzufügen einzelner Zellhalter in die Aufnahmevorrichtung möglich ist. Die in die Aufnahmevorrichtung eingesetzten Zellhalter sind vorzugsweise sicher in der Aufnahmevorrichtung befestigt und können vorzugsweise nur durch bewusste Betätigung der Löseeinheit aus der Aufnahmevorrichtung entfernt werden.

Die Aufnahmevorrichtung kann aus beliebig vielen Ebenen aufgebaut werden und ist daher in der Höhe sehr flexibel. Die flexible Anpassung der Breite der Auflageböden erlaubt es vorzugsweise beliebig viele Zellhalter in einer Ebene zu platzieren.

Die Erfindung betrifft auch ein System aus mindestens einem erfindungsgemäßen Zellhalter und mindestens einer erfindungsgemäßen Aufnahmevorrichtung, wobei auf mindestens einem Auflageboden oder Träger der Aufnahmevorrichtung wenigstens ein Zellhalter lösbar angeordnet ist.

Vorzugsweise ist vorgesehen, dass auf dem Auflageboden oder dem Träger der Aufnahmevorrichtung mehrere Zellhalter lösbar derart angeordnet sind, dass die Zellhalter von einer gemeinsamen Seite des Auflagebodens oder Trägers aus, vorzugsweise mittels Steckern, elektrisch kontaktierbar sind und/oder von einer gemeinsamen Seite des Auflagebodens oder Trägers aus von der Aufnahmevorrichtung lösbar sind.

Der Zellhalter weist vorzugsweise Buchsen zur elektrischen Kontaktierung des Zellhalters auf.

Die Buchsen sind vorzugsweise an einer schmalen Seite des Zellhalters angeordnet, insbesondere wodurch Stecker vor allem bei einer Anordnung mehrerer Zellhalter in einer Aufnahmevorrichtung kaskadenartig hintereinander eingesteckt werden können. Die Buchsen sind vorzugsweise zum horizontalen Einstecken von Steckern ausgerichtet.

Die Buchsen sind vorzugsweise Laborsteckbuchsen, insbesondere Bananenbuchsen und die Stecker sind vorzugsweise Laborstecker, insbesondere Bananenstecker.

Vorzugsweise ist der Zellhalter ausgebildet, um einen Mehrfachkontaktanschluss mit Mess- und/oder Stromanschlüssen zu ermöglichen. Der Zellhalter ist vorzugsweise derart ausgebildet, dass Mess- und Stromanschlüsse voneinander getrennt sind und dass mehrere Mess- und Stromleitungen an den Zellhalter angeschlossen werden können, ohne dass diese Leitungen die Handhabung von anderen Zellhalter in einer Aufnahmevorrichtung beeinflusst. Ein Mehrfachkontaktanschluss bedeutet vorzugsweise, dass mehrere Stecker an einer Buchse angeschlossen werden können, bspw. indem Stecker ineinandergesteckt werden, wie dies bei bekannten Laborsteckern der Fall ist, da jeder Stecker wiederum eine Buchse aufweist.

Der Zellhalter ist vorzugsweise so gestaltet, dass die Versorgungs- und/oder Messleitungen mittels Laborsteckern auf die Laborsteckbuchsen angeschlossen werden können. In diese Laborstecker können weitere Laborsteckern kaskadenartig hintereinander eingesteckt werden.

Die Platzierung der Buchsen nach vorne in waagerechter Richtung erlaubt es, dass mehrere Bananenstecker ineinander an den Zellhalter angeschlossen werden können. So können mehrere Messmethoden parallel verwendet werden. Die Buchsen sind vorzugsweise horizontal ausgerichtet.

Vorzugsweise ist vorgesehen, dass die Freigabeeinheit des Zellhalters derart relativ zu dem Auflageboden oder Träger angeordnet ist, dass diese nicht untergriffen werden kann, wenn sich der Zellhalter in der Aufnahmevorrichtung befindet.

Der Zellhalter erfordert vorzugsweise wenig Platzbedarf. Bspw. der begrenzte Platz in Klima- oder Temperaturkammern, in denen der Zellhalter verwendet werden kann, erfordert ein kompaktes Design des Zellhalters. Die Aufnahmevorrichtung kann in einer Klima- oder Temperaturkammer angeordnet sein.

Die Erfindung betrifft auch ein Verfahren zum Testen mindestens einer Batteriezelle, wobei die Batteriezelle in einen erfindungsgemäßen Zellhalter eingesetzt wird und während der Ausführung des Verfahrens in einem erfindungsgemäßen Zellhalter und /oder in einer erfindungsgemäßen Aufnahmevorrichtung lösbar gehalten ist.

Vorzugsweise kann eine sichere Kontaktierung einer Batteriezelle mit dem Zellhalter erfolgen. Die Batteriezellen ist vorzugsweise derart sicher eingespannt und/oder kontaktiert, sodass die Batteriezelle während eines langen Tests, dessen Testdauer über ein Jahr beträgt nicht den Kontakt verliert, nicht herausfällt, nicht abrutscht und/oder kein Kurzschluss ausgelöst wird.

Die Batteriezelle wird vorzugsweise auf den vom Zellhalter lösbaren, abgerundeten Aufnahmeabschnitt des Zellhalters gelegt. Nach der Einspannung der Batteriezelle ist die Batteriezelle dann zentriert und fest in dem Zellhalter aufgenommen, sodass bspw. ein Verrutschen der Batteriezelle nicht möglich ist.

Vorzugsweise ist vorgesehen, dass im Rahmen des Einsetzens der Batteriezelle eine Einstellung der Größe des Aufnahmeabschnitts des Zellhalters auf die jeweilige Größe der einzusetzenden Batteriezelle vorgenommen wird.

Insbesondere durch die Arretierungseinheit wird vorzugsweise eine hohe Geschwindigkeit des Einspannens der Batteriezelle in den Zellhalter ermöglicht. Das Einspannen der Batteriezelle in den Zellhalter erfordert vorzugsweise nur die zwei folgenden Schritte:
1. Einlegen der Batteriezelle in den Zellhalter;
2. Herandrücken des Verfahrschlittens an die Batteriezelle, bis die Arretierungseinheit arretiert.

Die Entnahme der Batteriezelle aus dem Zellhalter erfordert vorzugsweise nur die zwei folgenden Schritte, die in wenigen Sekunden erfolgen können:
1. Betätigung des Betätigungselements der Freigabeeinheit, wodurch die die Batteriezelle gelöst wird;
2. Entnehmen der Batteriezelle aus dem Zellhalter.

Der Umbau des Zellhalters von einem Zellformat auf das andere ist vorzugsweise durch einfaches Tauschen des Aufnahmeabschnitts möglich.

Die Herausnahme eines Zellhalters aus der Aufnahmevorrichtung sowie die sichere Befestigung des Zellhalters in der Aufnahmevorrichtung erfolgt vorzugsweise in wenigen Sekunden.

Vorzugsweise erlaubt der Zellhalter eine hohe Geschwindigkeit des Austausches der in dem Zellhalter angeordneten Batteriezelle durch eine andere Batteriezelle und/oder der Entnahme der in dem Zellhalter angeordneten Batteriezelle oder des Einsetzens einer Batteriezelle in den Zellhalter. Vorzugsweise können Batteriezellen in dem Zellhalter schnell verbaut werden. Insbesondere in einem Betrieb des Zellhalters und/oder der Aufnahmevorrichtung werden häufig viele Batteriezellen getauscht, wobei dafür möglichst wenig Zeit verwendet werden soll. Insbesondere daher verfügt der Zellhalter vorzugsweise über eine Schnellspannvorrichtung in Form der Arretierungseinheit.

Vorzugsweise erfolgt eine Messung der Coulombeffizienz von einer mehrerer Batteriezellen, wobei jede Batteriezelle in einem Zellhalter angeordnet ist, in einer Klimakammer oder in einer Temperaturkammer.

In der Temperaturkammer wird vorzugsweise nur die Temperatur und nicht zusätzlich Luftfeuchte und Druck geregelt, wie das bei einer Klimakammer der Fall ist bzw. sein kann.

Die Erfindung betrifft auch eine Verwendung eines erfindungsgemäßen Zellhalters und / oder einer erfindungsgemäßen Aufnahmevorrichtung zur lösbaren Fixierung mindestens einer Batteriezelle, vorzugsweise während der Ausführung eines Testverfahrens an der Batteriezelle.

An dieser Stelle wird darauf hingewiesen, dass die Begriffe "ein" und "eine" nicht zwingend auf genau eines der Elemente verweisen, wenngleich dies eine mögliche Ausführung darstellt, sondern auch eine Mehrzahl der Elemente bezeichnen können. Ebenso schließt die Verwendung des Plurals auch das Vorhandensein des fraglichen Elementes in der Einzahl ein und umgekehrt umfasst der Singular auch mehrere der fraglichen Elemente. Weiterhin können alle hierin beschriebenen Merkmale der Erfindung beliebig miteinander kombiniert oder voneinander isoliert beansprucht werden.

Weitere Vorteile, Merkmale und Effekte der vorliegenden Erfindung ergeben sich aus der nachstehenden Beschreibung bevorzugter Ausführungsbeispiele unter Bezugnahme auf die Figuren, in welchen gleiche oder ähnliche Bauteile durch dieselben Bezugszeichen bezeichnet sind. Hierbei zeigen:
- Fig. 1:: eine Seitenansicht einer Ausführungsform eines erfindungsgemäßen Zellhalters.
- Fig. 2:: eine Rückansicht einer Ausführungsform eines erfindungsgemäßen Zellhalters.
- Fig. 3:: eine Draufsicht einer Ausführungsform eines erfindungsgemäßen Zellhalters.
- Fig. 4:: eine perspektivische Ansicht einer Ausführungsform eines erfindungsgemäßen Zellhalters.
- Fig. 5:: eine perspektivische Ansicht eines Aufnahmeabschnitts einer Ausführungsform eines erfindungsgemäßen Zellhalters.
- Fig. 6:: ein Detail einer Seitenansicht einer Ausführungsform eines erfindungsgemäßen Zellhalters.
- Fig. 7:: drei Seitenansichten einer Ausführungsform eines erfindungsgemäßen Zellhalters in verschiedenen Zuständen.
- Fig. 8:: drei Details der Seitenansichten aus Fig. 7.
- Fig. 9:: eine Seitenansicht einer Ausführungsform eines erfindungsgemäßen Systems.
- Fig. 10:: eine Halbschnittansicht eines Details einer Seitenansicht einer Ausführungsform eines erfindungsgemäßen Systems.
- Fig. 11:: eine Halbschnittansicht eines Details einer Seitenansicht einer Ausführungsform eines erfindungsgemäßen Systems.
- Fig. 12:: eine perspektivische Ansicht einer Ausführungsform eines erfindungsgemäßen Systems.
- Fig. 13:: eine perspektivische Ansicht einer Ausführungsform einer erfindungsgemäßen Aufnahmevorrichtung.

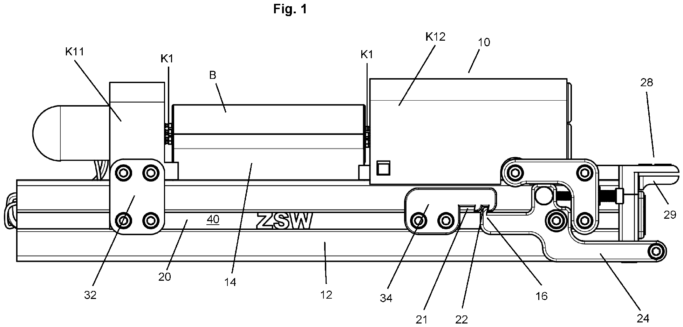

Der in Fig. 1 dargestellte Zellhalter 10 weist einen Grundkörper 12 und einen relativ zu dem Grundkörper 12 bewegbaren Verfahrschlitten 20 auf.

Ein Aufnahmeabschnitt 14 ist an dem Grundkörper 12 angeordnet.

Ferner ist eine erste Kontakteinheit K11 Bestandteil des Verfahrschlittens 20 und ist mit diesem bewegbar. Die erste Kontakteinheit K11 ist über ein Verbindungselement 32 mit einer Verfahrschiene 40 des Verfahrschlittens 20 verbunden.

Die erste Kontakteinheit K11 weist erste Kontakte K1 auf.

Ferner ist eine zweite Kontakteinheit K12 an dem Grundkörper 12 angeordnet und ist gegenüber dem Grundkörper 12 fixiert.

Die zweite Kontakteinheit K12 weist ebenfalls erste Kontakte K1 auf.

Die ersten Kontakte K1 sind federnd ausgebildet, sodass diese in die jeweilige Kontakteinheit Einfedern und aus dieser wieder Ausfedern können. Die ersten Kontakte K1 können auch als gefederte Pins oder Pin-Kontakte bezeichnet werden.

In dem Aufnahmeabschnitt 14 befindet sich eine Batteriezelle B, die mit den ersten Kontakten K1 in elektrisch leitenden Kontakt steht.

Der Zellhalter 10 weist ferner eine Arretierungseinheit mit einem Haken 16 sowie in Verfahrrichtung des Verfahrschlittens 20 voneinander beabstandete Aufnahmebereiche 21 und 22, die Bestandteile eines Aufnahmeelements 34 des Verfahrschlittens 20 sind auf.

Der Haken 16 befindet sich in dem hinteren Aufnahmebereich 22, wodurch der Verfahrschlitten 20 gegenüber dem Grundkörper 12 in einer Relativposition arretiert wird.

Durch eine Freigabeeinheit, die ein Betätigungselement in Form eines Hebels 24 aufweist, kann die Arretierung gelöst werden.

Der Haken 16 und der Hebel 24 sind Bestandteile eines Drehelements.

In der in Fig. 1 gezeigten Relativposition des Verfahrschlittens 20 gegenüber dem Grundkörper 12 wird eine in dem Aufnahmeabschnitt 14 befindliche Batteriezelle B zwischen den ersten Kontakten K1 bzw. zwischen den Kontakteinheiten K11 und K12 gehalten oder eingespannt.

Ferner weist der der Zellhalter 10 des Weiteren eine Verankerungseinheit 28 auf, welche dazu ausgelegt ist, den Zellhalter 10 mittels einer formschlüssigen Verbindung lösbar an einer Aufnahmevorrichtung 100 zu verankern, wobei die Verankerungseinheit 28 dazu ausgelegt ist, mit einer Schiene 104 der Aufnahmevorrichtung 100 lösbar zusammenzuwirken.

Die Verankerungseinheit 28 weist eine Löseeinheit auf, welche dazu ausgelegt ist, eine Verankerung des Zellhalters 10 an der Schiene 104 durch die Verankerungseinheit 28 bei einer Betätigung eines vorgespannten Betätigungselements der Löseeinheit zu lösen, wobei das Betätigungselement ein in Vertikalrichtung beweglicher Schieber 29 ist.

Die Verankerungseinheit 28 ist in anderen Worten ein Einrastmechanismus zur Befestigung des Zellhalters 10 in der Aufnahmevorrichtung 100.

Der Zellhalter 10 weist vorzugsweise eine Höhe von unter 70 mm, eine Länge von unter 250 mm und/oder eine Breite von unter 40 mm auf.

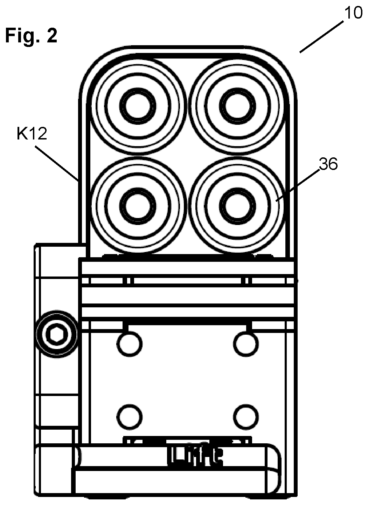

In Fig. 2 ist zu sehen, dass der Zellhalter 10 bzw. die zweite Kontakteinheit K12 vier Buchsen 36 aufweist, die in Form von Laborsteckbuchsen ausgebildet sind.

Die Buchsen 36 sind an der Rückseite des Zellhalters 10 angeordnet.

Die zweite Kontakteinheit K12 ist mit einer Abdeckkappe versehen. Unter der Abdeckkappe befinden sich die Verbindungsleitungen von den ersten Kontakten K1 in Form von gefederten Pins zu den Buchsen 36, die stromführende Buchsen und Messbuchsen umfassen.

Die ersten Kontakte K1 an jeder Kontakteinheit K11 und K12 umfassen jeweils n, insbesondere acht, Kontakte, wobei davon n-1, insbesondere sieben kreisförmig angeordnet sind und in dem Kreis zentriert der n-te Kontakt angeordnet ist.

Die kreisförmig angeordneten Kontakte sind zur Versorgung der Batteriezelle B mit Strom ausgebildet. Bei sieben Kontakten an jeder Kontakteinheit K11 und K12 ergibt dies insgesamt 14 Kontakte für die Stromversorgung.

Die zentriert in dem Kreis angeordneten Kontakte auf jeder Seite sind zur Messung, insbesondere der Spannung, der Batteriezelle B ausgebildet.

Je Kontakteinheit K11 und K12 ist eine elektrische Leitung mit den in dem Kreis angeordneten Kontakten verbunden, insbesondere gelötet. Jede dieser zwei Leitungen ist mit einer Buchse 36 verbunden, insbesondere gelötet.

Jeder n-te Kontakt jeder Kontakteinheit ist auch mit einer elektrischen Leitung verbunden, insbesondere verlötet, wobei jede dieser zwei Leitungen mit einer Buchse 36 verbunden, insbesondere verlötet, ist.

Aus dieser Anordnung ergeben sich vier Buchsen 36, wobei zwei Buchsen 36 Messbuchsen und zwei Buchsen 36 Versorgungsbuchsen sind.

Es erfolgt somit eine Trennung von Spannungsmessung durch die zwei n-ten Kontakte, die jeweils mit einer Messleitung verbunden sind und Stromführung durch die zwei n-1 Kontakte, die jeweils mit einer Stromleitung verbunden sind.

Die Trennung von Stromleitung und Messleitung so nahe wie möglich an der Batteriezelle B ist vorzugsweise wichtig für genaue Messungen. Werden beide Signale auf der gleichen Leitung geführt, entstehen Spannungsverluste entlang der Leitung, die das Signal verfälschen.

An dem Zellhalter 10, insbesondere an der Rückseite des Zellhalters können mit Nummern oder sonstigen Kennzeichen gekennzeichnete Plaketten angeordnet werden, die eine Kennzeichnung des Zellhalters ermöglichen.

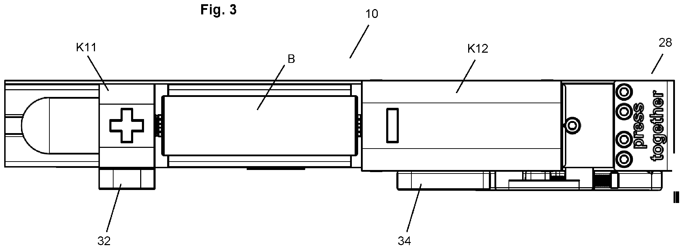

Fig. 3 zeigt den Zellhalter 10 in einer Draufsicht. Der Zellhalter 10 weist an Kontakteinheiten K11 und K12 Markierungen, in diesem Beispiel in Form eines Plus- und Minus-Zeichens, auf, die anzeigen welcher Pol der Batteriezelle B welchem ersten Kontakt K1 bzw. welcher Kontakteinheit K11 und K12 zugeordnet werden soll. Die Markierungen kennzeichnen damit eine Position der Batteriezelle B.

Der Zellhalter 10 weist nur ein Verbindungselement 32 und ein Aufnahmeelement 34 an einer Seite auf. Denkbar ist aber eine Ausführungsform in der auf beiden Seiten des Zellhalters 10 jeweils eines der genannten Elemente vorhanden ist. Die Elemente der Arretierungseinheit können auf beiden langen Seiten des Zellhalters 10 angeordnet sein.

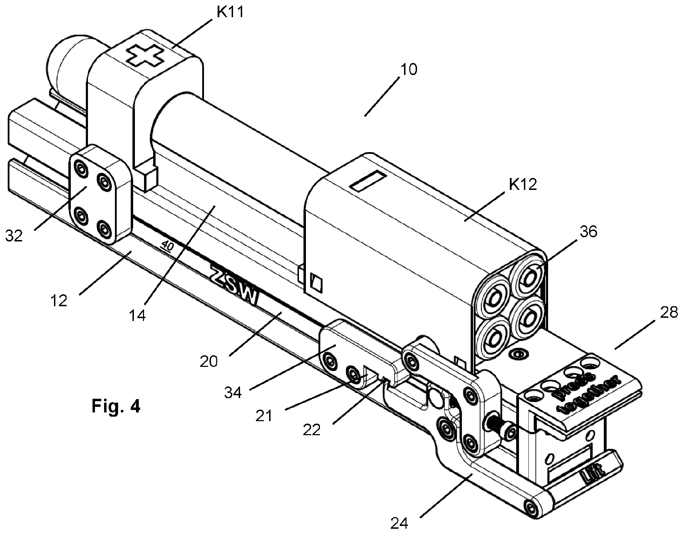

In Fig. 4 ist zu erkennen, dass der Verfahrschlitten 20 die in dem Grundkörper 12 geführte Verfahrschiene 40, die erste Kontakteinheit K11 sowie das Aufnahmelement 34 umfasst.

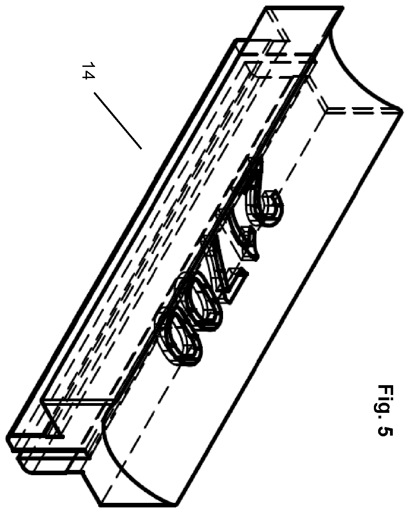

In Fig. 5 ist eine perspektivische Ansicht eines Aufnahmeabschnitts 14 für den Typ 21700 dargestellt, wie dies aus der Kennzeichnung mit der Zahl "21700" auf dem Aufnahmeabschnitt 14 ersichtlich ist.

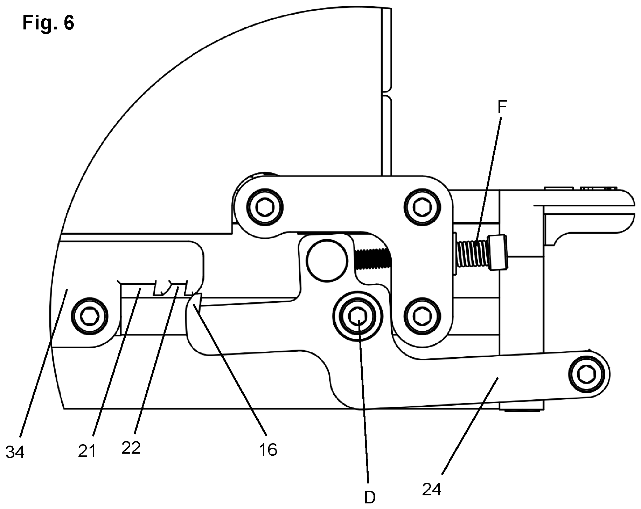

Anhand Fig. 6 kann die Funktionsweise der Arretierungseinheit beschrieben werden.

Die Arretierungseinheit umfasst das Aufnahmeelement 34 mit den Aufnahmebereichen 21 und 22, sowie den Haken 16.

Der Haken 16 ist mit dem Hebel 24 in dem Drehelement einstückig ausgeführt.

Das Drehelement ist drehbar an dem Zellhalter gelagert und kann um den Drehpunkt D gedreht werden.

Das Drehelement ist über eine Feder F vorgespannt, die bewirkt, dass das Drehelement mit dem Uhrzeigersinn gedreht wird, wenn keine äußere Kraft auf das Drehelement einwirkt, bis das Drehelement an einem Anschlag anliegt und annähernd horizontal steht und eine Ausgangsposition einnimmt.

Die Feder F dient zur automatischen Rückführung des Drehelements in die Ausgangsposition nach Betätigung.

Die Feder F ist auf eine Schraube aufgesteckt, die durch ein Halteelement geführt ist und mit dem Drehelement verschraubt ist. Die Feder F ist zwischen dem Halteelement und dem Schraubenkopf der Schraube angeordnet. Durch Drehen der Schraube kann die Federkraft eingestellt werden. Das Drehelement weist eine drehbare Mutter auf, mit der die Schraube verschraubt ist.

Das Halteelement ist L-förmig ausgebildet.

Der Verfahrschlitten 20 kann gegenüber dem Grundkörper 20 vor- und zurückgeschoben werden.

Der Verfahrschlitten 20 umfasst die erste Kontakteinheit K11, die Verfahrschiene 40, das Verbindungselement 32 und das Aufnahmeelement 34, wobei die erste Kontakteinheit K11 über das Verbindungselement 32 mit der Verfahrschiene 40 durch eine Verschraubung verbunden ist und das Aufnahmeelement 34 durch eine Verschraubung mit der der Verfahrschiene 40 verbunden ist.

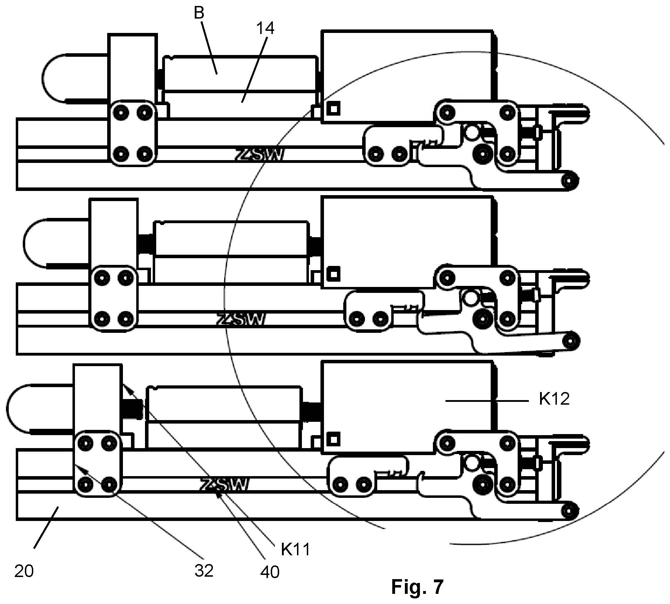

Wie dies aus Fig. 7 hervorgeht kann der Verfahrschlitten 20 entlang des Grundkörpers 20 in Fig. 7 nach links und rechts verschoben werden.

In Fig. 7 sind drei Zustände des Zellhalters 10 dargestellt, wobei der Verfahrschlitten 20 jeweils verschiedene Positionen einnimmt.

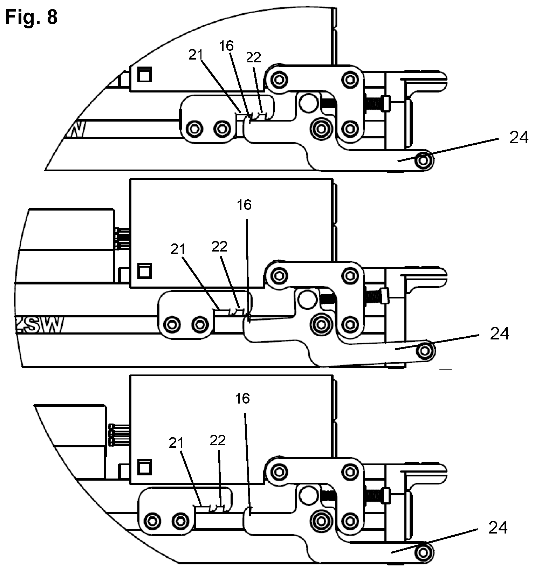

Aus der Detailansicht der Fig. 7 in Fig. 8 gehen die Stellungen der Arretierungseinheit bei verschiedenen Positionen des Verfahrschlittens 20 hervor.

Eine Batteriezelle B befindet sich auf dem Aufnahmeabschnitt 14.

In der unteren Darstellung von Fig. 7 bzw. Fig. 8 ist die Batteriezelle B zwischen den ersten Kontakteinheiten K11 und K12 frei liegend und nicht durch diese eingespannt. Es liegt damit ein nicht kontaktierter Zustand der Batteriezelle B vor.

In der mittleren Darstellung von Fig. 7 wird der Verfahrschlitten 20 in Richtung der zweiten Kontakteinheit K12 verschoben, um die Batteriezelle zwischen der ersten Kontakteinheit K11 und der zweiten Kontakteinheit K12 einzuspannen. Es erfolgt damit ein Spannvorgang.

In der oberen Darstellung von Fig. 7 ist die Batteriezelle B zwischen den ersten Kontakteinheiten K11 und K12 eingespannt und damit fixiert. Die Batteriezelle B befindet sich in einem eingespannten Zustand.

Die fest miteinander verbundenen Elemente des Verfahrschlittens 20 können in Fig. 7 bzw. in Fig. 8 nach links und rechts geschoben werden.

Beim Schieben des Verfahrschlittens 20 in Richtung der zweiten Kontakteinheit K12 drehen sich das Drehelement mit dem Hebel 24 und dem Haken 16 gegen den Uhrzeigersinn, solange Kontakt zwischen dem Haken 16 und dem Aufnahmeelement 34 besteht, wie dies insbesondere aus der mittleren Darstellung aus Fig. 8 hervorgeht.

Weiteres Schieben des Verfahrschlittens 20 in Richtung der zweiten Kontakteinheit K12 lässt das Drehelement bzw. den Haken 16 durch die Feder F im Uhrzeigersinn zurückdrehen, wobei der Haken 16 in den Aufnahmebereich 21 des Aufnahmeelements 34 einrastet, wie dies insbesondere aus der oberen Darstellung aus Fig. 8 hervorgeht.

Eine Bewegung des Hebels 24 nach oben dreht das Drehelement bzw. den Haken 16 erneut gegen den Uhrzeigersinn und gibt die Einrastung frei, womit der Verfahrschlitten 20 wieder nach links geschoben werden kann und der in Fig. 7 bzw. in Fig. 8 in der unteren Darstellung dargestellte Zustand eingenommen werden kann.

Die Länge der Batteriezelle B bestimmt den Aufnahmebereich 21 oder 22 in den der Haken 16 einrastet. Bei einer kürzeren Batteriezelle B kann der Haken 16 in den Aufnahmebereich 21 einrasten und bei einer längeren Batteriezelle B kann der Haken 16 nur in den Aufnahmebereich 22 einrasten.

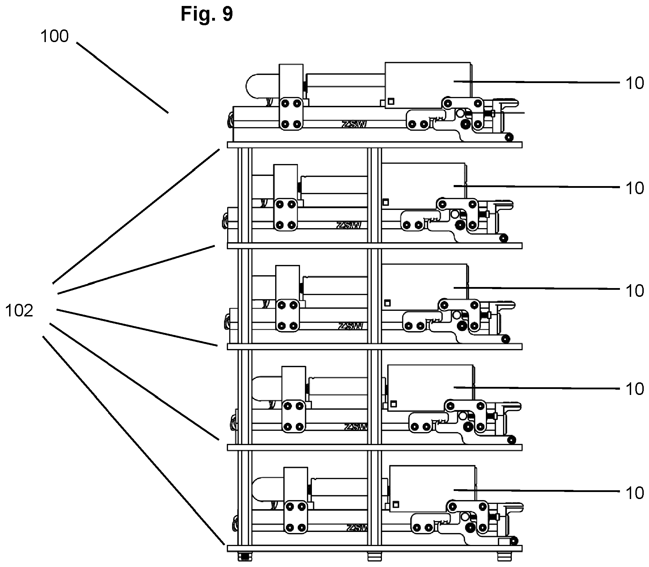

In Fig. 9 ist eine Aufnahmevorrichtung 100 in Form eines Gestells, das mehrere Auflageböden 102 aufweist, wobei an den Auflageböden 102 Zellhalter 10 lösbar angeordnet sind, dargestellt.

Die Auflageböden 102 weisen Schienen 104 auf, die jeweils zur lösbaren Verankerung eines Zellhalters 10 an der Aufnahmevorrichtung 100 ausgebildet sind auf.

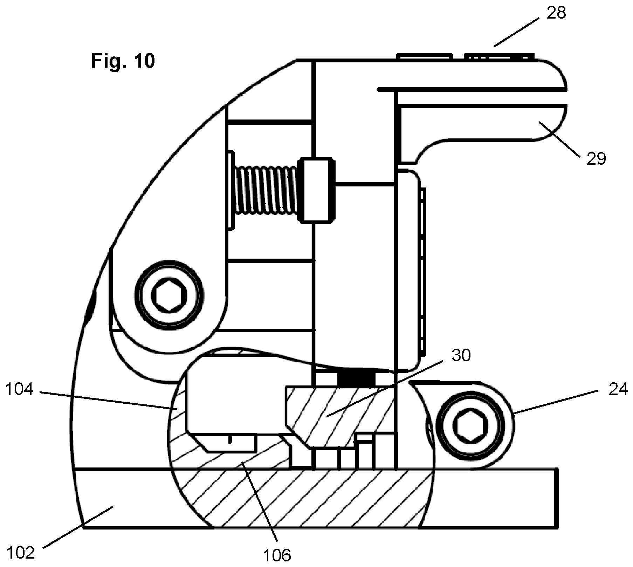

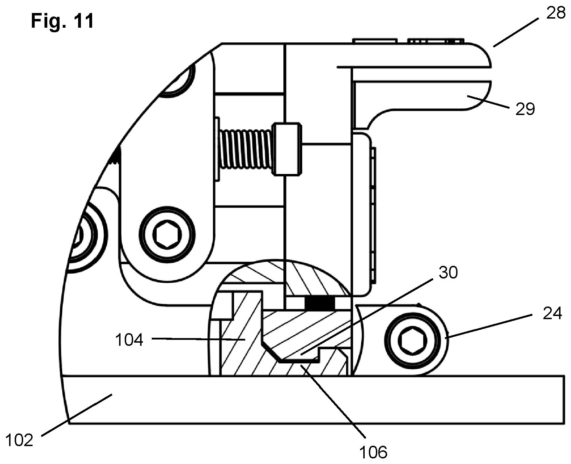

Der Vorgang des Verankerns eines Zellhalters 10 an einer Schiene 104 ist in den Fig. 10 und 11 dargestellt.

Der Schieber 29 oder Clip der Verankerungseinheit 28 ist in Fig. 10 nicht betätigt.

Dabei ist der Vorsprung 30 in Form eines Hakens maximal nach unten ausgelenkt.

Der Zellhalter 10 wird auf die Schiene 104 in Fig. 10 von rechts nach links aufgeschoben. Die Schiene weist eine Vertiefung 106 auf.

Die Schiene 104 und der Vorsprung 30 weisen jeweils eine Fase, bspw. mit einem Fasenwinkel von 45° auf. Die Flächen der Fasen berühren sich beim Aufschieben des Zellhalters 10 auf die Schiene 104. Dabei wird der Vorsprung 30 des Zellhalters 10 nach oben geschoben.

Zwischen dem Schieber 29 und dem Vorsprung 30 besteht eine derartige Verbindung, dass die Bewegungen des Schiebers 29 und des Vorsprungs 30 zusammenhängen. Bspw. ein Bewegen des Vorsprungs 30 oder des Schiebers 29 nach oben bewirkt ein Bewegen des Schiebers 29 oder des Vorsprungs 30 nach oben.

Beim Aufschieben des Zellhalters 10 auf die Schiene 104 wird daher auch der Schieber 29 bei der Bewegung des Vorsprungs 30 nach oben, nach oben geschoben.

Der Vorsprung 30 ist durch eine Rückstellfeder vorgespannt, sodass dieser durch die Rückstellfeder nach unten gedrückt wird.

Die Rückstellfeder bewirkt somit eine Gegenkraft gegen die Verschiebung des Vorsprungs 30 nach oben beim Aufschieben des Zellhalters 10 auf die Schiene 104.

Beim Weiteren Aufschieben des Zellhalters 10 auf die Schiene 104 wird der Vorsprung 30 maximal noch oben bewegt.

Der Schieber 29 ist dabei nicht vollständig zusammengedrückt und der Zellhalter 10 lässt sich vollständig auf die Schiene 104 aufschieben. Eine untere Fläche des Vorsprungs 30 am Zellhalter 10 und eine obere Fläche der Schiene 104, die an die Fase der Schiene 104 anschließt berühren sich dabei.

Der Zellhalter 10 kann soweit auf die Schiene 104 aufgeschoben werden, bis der Vorsprung 30 an einer Anschlagfläche anliegt.

Die Anschlagfläche schließt sich an die Vertiefung 106 an.

In einer Position des Vorsprungs 30 bzw. des Zellhalters 10 in der der Vorsprung 30 an der Anschlagfläche anliegt wird der Vorsprung 30 durch die Rückstellfeder in die Vertiefung 106 gedrückt.

Auch der Schieber 29 wird durch die Federkraft der Rückstellfeder nach vollständigem Aufschub des Zellhalters 10 wieder vollständig in seine Ausgangsposition gebracht.

Der Vorsprung 30 und die Vertiefung 106 sind nun ineinander eingerastet. Die Geometrie erlaubt es nicht, dass die Verbindung ohne Betätigung des Schiebers 29 getrennt werden kann. Die Federkraft der Rückstellfeder drückt den Vorsprung 30 des Zellhalters 10 in die Vertiefung 106 der Schiene 104. Dies ist in Fig. 11 dargestellt.

Nach dem Aufschieben des Zellhalters 10 auf die Schiene 104 bzw. Anordnen des Zellhalters 10 in der Aufnahmevorrichtung 100 ist es nicht möglich den Hebel 24 zu betätigen, wodurch die Einspannung der Batteriezelle B gelöst werden würde. Dieser Sicherheitsmechanismus verhindert versehentliches Öffnen des Zellhalters 10 und dadurch offenen Kontakt der Batteriezelle B.

Der Hebel 24 liegt somit eng an dem Auflageboden 102 an, sodass ein Untergreifen des Hebels 24 mit einem Finger nicht mehr möglich ist. Der Abstand zwischen Hebel 24 und Auflageboden 102 beträgt bspw. weniger als 1 cm.

Eine Entnahme des Zellhalters 10 von der Schiene 104 erfolgt durch Zusammendrücken des Schiebers 29, wobei der Vorsprung 30 des Zellhalters 10 nach oben bewegt oder gezogen wird. Dadurch wird der Vorsprung aus der Vertiefung 106 der Schiene 104 bewegt. Der Zellhalter 10 kann von der Schiene 104 entnommen werden.

Zwischen den der unteren Fläche des Vorsprungs 30 und der oberen Fläche der Schiene 104 entsteht ein Abstand. Die Flächen berühren sich nicht mehr bei Verschieben des Zellhalters, wenn der Schieber 20 vollständig nach oben gedrückt wird, wodurch ein Abnehmen des Zellhalters von der Schiene 104 möglich wird.

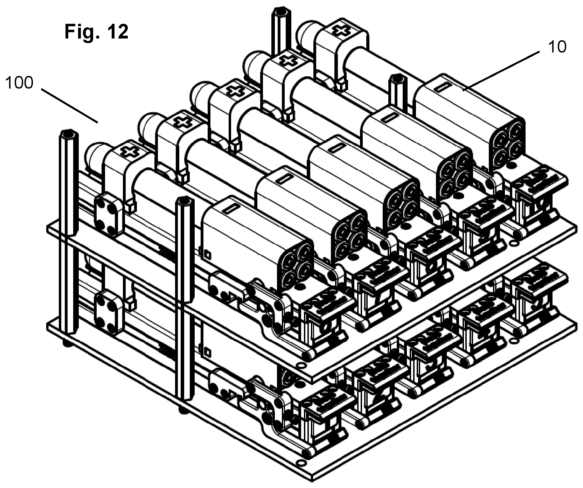

Fig. 12 zeigt eine beispielhafte Anordnung von Zellhaltern in der Aufnahmevorrichtung 100.

Die Maße einer Aufnahmevorrichtung 100 mit zehn Zellhaltern betragen vorzugsweise weniger als 180 mm in der Höhe, weniger als 260 mm in der Länge und weniger als 260 mm in der Breite.

Die Länge bzw. Tiefe der Aufnahmevorrichtung 100 beträgt bspw. 25 cm. Die Breite des Zellhalters ist variabel und beträgt bspw. 5 cm für jede Batteriezelle. Bei fünf Batteriezelle sind somit ca. 25 cm an Breite vorhanden.

Die untere Ebene der Aufnahmevorrichtung 100 ist bspw. 8 cm hoch. Für jede weitere gestapelte Ebene werden bspw. weitere 7.2 cm in der Höhe benötigt.

Die Konstruktion des Zellhalters 10 ist platzsparend insbesondere dadurch, dass an allen Seiten des Zellhalters 10 Bauelemente angebracht sind. In der Aufnahmevorrichtung 100 sind die Zellhalter bzw. Batteriezellen sehr eng aneinander platziert und dennoch ist genügend Platz um die Batteriezellen herum, sodass in waagerechter Richtung Luft durch die Aufnahmevorrichtung 100 geleitet werden kann.

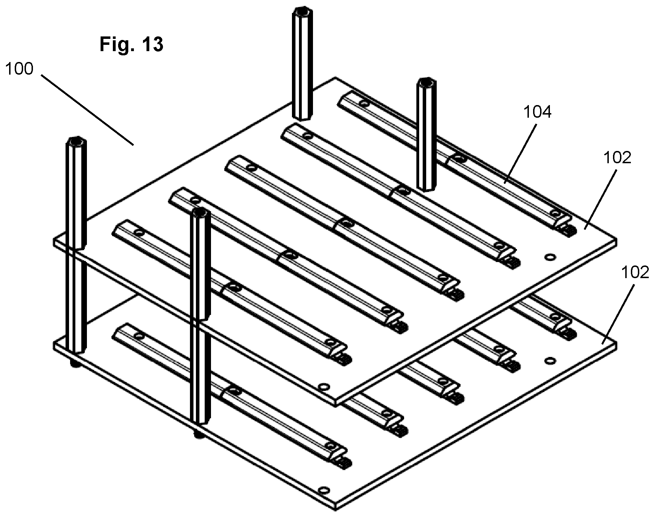

In Fig. 13 ist eine leere Aufnahmevorrichtung für zehn Zellhalter 10 dargestellt. Es können mehrere Ebenen von Zellhaltern auf den Auflageböden 102 übereinandergestapelt werden. Die Schienen 104 verlaufen nebeneinander parallel auf den Auflageböden 102.

Eine sichere Einspannung einer Batteriezelle in den Zellhalter kann in einem Ausführungsbeispiel des erfindungsgemäßen Verfahrens wie folgt beschrieben werden: Der Verfahrschlitten kann nach vorne und hinten bewegt werden. Vorne bezeichnet den Bereich in dem die erste Kontakteinheit angeordnet ist und hinten bezeichnet den Bereich in dem die zweite Kontakteinheit angeordnet ist. Durch das nach vorne Ziehen oder Schieben wird die Arretierungseinheit, die auch als Auslösemechanismus bezeichnet werden kann und/oder ein gefedertes Hakensystem an der Seite des Zellhalters ist, aktiviert. Dabei dreht sich der Haken gegen den Uhrzeigersinn, solange Kontakt zu dem Aufnahmeelement besteht. Sobald der Schwellpunkt überschritten ist, haken die beiden Elemente Haken und Aufnahmeelement ineinander ein. Eine Rückstellfeder bringt den Haken wieder im Uhrzeigersinn in seine Ausgangsposition zurück. Nur eine forcierte Bewegung des vorne am Zellhalter angebrachten Hebels, der mechanisch fest mit dem Haken verbunden ist und bspw. die Aufschrift "lift" trägt, nach oben dreht den Haken dann erneut gegen den Uhrzeigersinn. Gibt es keine Gegenkraft, die den Verfahrschlitten nach vorne drückt, so wird der Teil aufgrund der Federkräfte der gefederten ersten Kontakte oder Pins nach hinten weggedrückt. Durch die Massenträgheit entsteht beim Stillstand des verschiebbaren Verfahrschlittens so viel Platz zwischen den ersten Kontakten auf beiden Seiten der Batteriezelle zur Batteriezelle, dass diese einfach herausgenommen werden kann. Es sind in dem Aufnahmeelement vorzugsweise zwei Einrastpositionen vorhanden, die jeweils durch Aufnahmebereiche für den Haken gebildet werden. Wird eine Batteriezelle vom Typ 18650 verwendet, so wird der Verfahrschlitten nach dem ersten Einrasten des Hakens in den ersten Aufnahmebereich weiter in Richtung der Batteriezelle gedrückt und rastet ein zweites Mal in den zweiten Aufnahmebereich ein. Dadurch wird sichergestellt, dass die kürzere Batteriezelle vom Typ 18650 sicher eingespannt ist. Für Batteriezellen vom Typ 21700 wird der erste Aufnahmebereich verwendet. Über insgesamt sieben kreisförmig angeordnete gefederte Pin-Kontakte, mit einem Maximalstrom von je 1,5 A für die Zyklisierung und einen dazu mittig platzierten gefederten Pin-Kontakt zur Messung der Zellspannung auf beiden Seiten des Zellhalters, in welchem die Batteriezelle eingespannt wird, wird sichergestellt, dass die Batteriezelle über lange Zeit rüttelfest, kurzschlusssicher und statisch stabil gelagert ist und die Kontaktierung stets gewährleistet ist.

Ein Umbau des Zellhalters, um den Zellhalter an verschiedene Typen oder Formate von Batteriezellen anzupassen kann in einem Ausführungsbeispiel des erfindungsgemäßen Verfahrens wie folgt beschrieben werden: Der Umbau von einem Zellformat auf das andere ist durch einfaches Tauschen des Aufnahmeabschnitts möglich. Die Aufnahmeabschnitte weisen vorzugsweise einen Anfangswiderstand bei der Herausnahme auf, weil dann die im Grundkörper liegenden Finnen des Aufnahmeabschnitts zusammengedrückt werden. Dadurch wird bei Wiedereinlegen sichergestellt, dass der Aufnahmeabschnitt nicht herausrutschen kann. Eine Kerbe auf beiden Seiten der Finnen sorgt dafür, dass der Aufnahmeabschnitt in seiner finalen Position einrastet.

Eine Verankerung des Zellhalters in der Aufnahmevorrichtung kann in einem Ausführungsbeispiel des erfindungsgemäßen Verfahrens wie folgt beschrieben werden: In einer ersten Position ist der Zellhalter bereits zum Großteil auf die Schiene geschoben, aber der Haken ist nicht eingerastet. Wird der Zellhalter weiter auf die Schiene aufgeschoben, so wird der Vorsprung an der Vorderseite des Zellhalters unten, welcher über eine 45°-Fase verfügt gegen die Schiene, welche ebenfalls über eine 45°-Fase verfügt, gepresst, woraufhin sich der Schieber nach oben verschiebt. Wird der Zellhalter weiter über die Schiene geschoben, so wird der Schieber maximal komprimiert. Sobald der Zellhalter vollständig aufgeschoben ist, klickt der Schieber nach unten und der Zellhalter ist sicher fixiert. Der Aufschiebevorgang sollte schnell erfolgen, um die Reibung zwischen dem Vorsprung und der Schiene zu verringern und einen einfachen Aufschiebevorgang zu ermöglichen. Um den Zellhalter wieder zu entfernen, wird der Schieber zusammengepresst, wodurch sich der Vorsprung des Zellhalters nach oben schiebt. Daraufhin kann der Zellhalter herausgezogen werden. Der Schieber kann auch bereits beim Einschieben des Zellhalters in die Aufnahmevorrichtung bzw. beim Aufschieben auf die Schiene gedrückt und nach vollständigem Einschieben oder Aufschieben entspannt werden. So ist der Kraftaufwand beim Schieben geringer.

## Patentansprüche

1. Zellhalter (10) zum lösbaren Halten einer, vorzugsweise einer einzigen, Batteriezelle (B), vorzugsweise einer Rundzelle, wobei der Zellhalter (10) einen Grundkörper (12) aufweist sowie einen Aufnahmeabschnitt (14) für die Batteriezelle (B), wobei der Zellhalter (10) des Weiteren einen oder mehrere erste Kontakte (K1) aufweist, die derart angeordnet sind, dass diese bei einer in dem Aufnahmeabschnitt (14) befindlichen Batteriezelle (B) mit einem oder mehreren zweiten Kontakten der Batteriezelle (B) in elektrisch leitenden Kontakt gebracht werden können, wobei der Aufnahmeabschnitt (14) in einer oder mehreren Dimensionen derart veränderbar ausgebildet ist, dass in dem Aufnahmeabschnitt (14) des Zellhalters (10) Batteriezellen (B) mindestens zweier unterschiedlicher Größen kontaktierend aufnehmbar sind.

2. Zellhalter (10) gemäß Anspruch 1, **dadurch gekennzeichnet, dass** mehrere erste Kontakte (K1) vorhanden sind, von denen zumindest einer zur Spannungsversorgung ausgebildet ist, und von denen zumindest ein weiterer, von dem Kontakt (K1) zur Spannungsversorgung getrennter Kontakt (K1) zur Messung zumindest eines Parameters, vorzugsweise zur Spannungsmessung ausgebildet ist, wobei vorzugsweise vorgesehen ist, dass die Anzahl der zur Spannungsversorgung ausgebildeten Kontakte (K1) größer ist als die Anzahl der zur Messung ausgebildeten Kontakte (K1).

3. Zellhalter (10) gemäß Anspruch 1 oder 2, **dadurch gekennzeichnet, dass** der Zellhalter (10) derart ausgelegt ist, dass in dem Zellhalter (10) Batteriezellen (B) des Typs 18650 oder 21700 kontaktierend aufnehmbar sind und/oder dass der Zellhalter (10), vorzugsweise dessen Aufnahmeabschnitt (14), eine Kennzeichnung aufweist, die die Batteriezelle (B) und/oder den Zellhalter (10), insbesondere dessen Aufnahmeabschnitt (14), und/oder eine Messapparatur zur Messung der in dem Zellhalter (10) befindlichen Batteriezelle (B) kennzeichnet und/oder eine Zuordnung zwischen Batteriezelle (B) und/oder Zellhalter (10), insbesondere dessen Aufnahmeabschnitt (14), und/oder Messapparatur aufweist.

4. Zellhalter (10) gemäß einem der vorhergehenden Ansprüche, **dadurch gekennzeichnet, dass** der Aufnahmeabschnitt (14) eine vorzugsweise wannenförmige, wellenförmige oder stegförmige Vertiefung oder sonstige Ablage aufweist oder umfasst, in welche die Batteriezelle (B) einlegbar ist, wobei der Aufnahmeabschnitt (14) relativ zu dem Grundkörper (12) modular und / oder auswechselbar ausgestaltet ist, und/oder wobei vorzugsweise vorgesehen ist, dass die Vertiefung eine zu der Außenseite der Batteriezelle (B) komplementäre Form aufweist, wobei vorzugsweise vorgesehen ist, dass die Vertiefung oder sonstige Ablage eine oder mehrere Aussparungen aufweist, insbesondere zum Zwecke der Wärmeabfuhr und/oder zur Platzierung von funktionalen Elementen, wie vorzugsweise Sensoren, an oder in der Vertiefung oder der sonstigen Ablage.

5. Zellhalter (10) gemäß einem der vorhergehenden Ansprüche, **dadurch gekennzeichnet, dass** der Zellhalter (10) einen relativ zu dem Grundkörper (12) bewegbaren Verfahrschlitten (20) aufweist, welcher dazu ausgelegt ist, eine in dem Zellhalter (10) aufgenommene Batteriezelle (B) lösbar in dem Zellhalter (10) zu fixieren und / oder in diesem einzuspannen, wobei vorzugsweise vorgesehen ist, dass der Aufnahmeabschnitt (14) einen Bestandteil des Verfahrschlittens (20) bildet oder lösbar mit dem Verfahrschlitten (20) in Verbindung steht und mit diesem bewegbar ist und/oder dass der Aufnahmeabschnitt (14) zwischen einen Teil des Grundkörpers (12) und einem Teil des Verfahrschlittens (20) angeordnet ist.

6. Zellhalter (10) gemäß Anspruch 5, **dadurch gekennzeichnet, dass** der Zellhalter (10) des Weiteren eine Arretierungseinheit aufweist, vorzugsweise in Form mindestens eines Formschlusselements, mittels welcher der Verfahrschlitten (20) relativ zu dem Grundkörper (12) in einer gewünschten Relativposition zwischen dem Verfahrschlitten (20) und dem Grundkörper (12) arretierbar ist.

7. Zellhalter (10) nach Anspruch 6, **dadurch gekennzeichnet, dass** die Arretierungseinheit einen oder mehrere vorzugsweise vorgespannte Vorsprünge, vorzugsweise Haken (16) sowie mehrere in Verfahrrichtung des Verfahrschlittens (20) voneinander beabstandete Aufnahmebereiche (21, 22) für den oder die Vorsprünge aufweist, wobei vorzugsweise vorgesehen ist, dass der oder die Vorsprünge relativ zu den Aufnahmebereichen (21, 22) verschwenkbar sind und/oder an dem Grundkörper (12) angeordnet sind.

8. Zellhalter (10) gemäß Anspruch 6 oder 7, **dadurch gekennzeichnet, dass** der Zellhalter (10) des Weiteren eine Freigabeeinheit aufweist, mittels welcher eine durch die Arretierungseinheit bedingte Arretierung des Verfahrschlittens (20) relativ zu dem Grundkörper (12) lösbar ist, wobei die Freigabeeinheit vorzugsweise wenigstens ein relativ zu dem Grundkörper bewegliches Betätigungselement aufweist, das vorzugsweise als Hebel (24) ausgeführt ist und/oder dass der oder die Vorsprünge an dem Betätigungselement angeordnet sind.

9. Zellhalter (10) gemäß einem der vorhergehenden Ansprüche, **dadurch gekennzeichnet, dass** der Zellhalter (10) des Weiteren eine Verankerungseinheit (28) aufweist, welche vorzugsweise einen Vorsprung (30) aufweist und welche dazu ausgelegt ist, den Zellhalter vorzugsweise mittels einer formschlüssigen Verbindung lösbar an einer Aufnahmevorrichtung (100), vorzugsweise an einem Gestell für den Zellhalter (10), zu verankern, wobei die Verankerungseinheit (28) dazu ausgelegt ist, mit einem Haltemittel, vorzugsweise mit einer Schiene (104) der Aufnahmevorrichtung (100) lösbar zusammenzuwirken, wobei vorzugsweise vorgesehen ist, dass die Verankerungseinheit (28) weiterhin eine Löseeinheit aufweist, welche dazu ausgelegt ist, eine Verankerung des Zellhalters (10) an dem Haltemittel durch die Verankerungseinheit (28) bei einer Betätigung eines vorzugsweise vorgespannten Betätigungselements der Löseeinheit zu lösen, wobei das Betätigungselement ein vorzugsweise in Vertikalrichtung beweglicher Hebel oder Schieber (29) ist.

10. Zellhalter (10) gemäß Anspruch 9, wobei die Verankerungseinheit (28) derart ausgebildet ist, dass eine Verankerung des Zellhalters (10) an dem Haltemittel durch die Verankerungseinheit (28) ausschließlich durch eine Betätigung des Betätigungselements der Löseeinheit lösbar ist.

11. Aufnahmevorrichtung (100), vorzugsweise Gestell, für mindestens einen Zellhalter (10) gemäß einem der vorhergehenden Ansprüche, mit einem Grundgestell und mindestens einem Auflageboden (102) oder Träger, an welchem mindestens ein Haltemittel, vorzugsweise mindestens eine Schiene (104) angeordnet ist, die zur lösbaren Verankerung des mindestens eines Zellhalters (10) an der Aufnahmevorrichtung (100) ausgebildet ist.

12. Aufnahmevorrichtung (100) nach Anspruch 11, **dadurch gekennzeichnet, dass** mehrere Auflageböden (102) oder Träger nebeneinander und/oder in zwei oder mehr als zwei Ebenen oder versetzt übereinander angeordnet sind und/oder dass das mindestens eine Haltemittel mindestens ein Formschlusselement, vorzugsweise eine Vertiefung (106), aufweist, welches dazu ausgelegt ist, mit einer Verankerungseinheit (28) eines an dem Haltemittel verankerten Zellhalters (10) lösbar zusammenzuwirken.

13. Aufnahmevorrichtung (100) gemäß Anspruch 11 oder 12, **dadurch gekennzeichnet, dass** auf dem mindestens einen Auflageboden (102) oder Träger eine Mehrzahl an Haltemitteln nebeneinander angeordnet sind, wobei es sich bei den Haltemitteln vorzugsweise um Schienen (104) handelt, die parallel oder im Wesentlichen parallel zueinander angeordnet sind, wobei vorzugsweise vorgesehen ist, dass die Formschlusselemente der Schienen (104) zu einer gemeinsamen Seite des Auflagebodens (102) oder Trägers ausgerichtet sind.

14. System aus mindestens einem Zellhalter (10) gemäß einem der Ansprüche 1 bis 10 und mindestens einer Aufnahmevorrichtung (100) gemäß einem der Ansprüche 11 bis 13, wobei auf mindestens einem Auflageboden (102) oder Träger der Aufnahmevorrichtung (100) wenigstens ein Zellhalter (10) lösbar angeordnet ist.

15. System gemäß Anspruch 14, **dadurch gekennzeichnet, dass** auf dem Auflageboden (102) oder dem Träger der Aufnahmevorrichtung (100) mehrere Zellhalter (10) lösbar derart angeordnet sind, dass die Zellhalter (10) von einer gemeinsamen Seite des Auflagebodens (102) oder Trägers aus, vorzugsweise mittels Steckern, elektrisch kontaktierbar sind und/oder von einer gemeinsamen Seite des Auflagebodens (102) oder Trägers aus von der Aufnahmevorrichtung (100) lösbar sind und/oder dass die Freigabeeinheit des Zellhalters (10) derart relativ zu dem Auflageboden (100) oder Träger angeordnet ist, dass diese nicht untergriffen werden kann, wenn sich der Zellhalter (10) in der Aufnahmevorrichtung (100) befindet.

16. Verfahren zum Testen mindestens einer Batteriezelle (B), wobei die Batteriezelle (B) in einen Zellhalter (10) gemäß einem der Ansprüche 1 bis 10 eingesetzt wird und während der Ausführung des Verfahrens in einem Zellhalter (10) gemäß einem der Ansprüche 1 bis 10 und /oder in einer Aufnahmevorrichtung (100) gemäß einem der Ansprüche 11 bis 13 lösbar gehalten ist, wobei vorzugsweise vorgesehen ist, dass im Rahmen des Einsetzens der Batteriezelle (B) eine Einstellung der Größe des Aufnahmeabschnitts (14) des Zellhalters (10) auf die jeweilige Größe der einzusetzenden Batteriezelle (B) vorgenommen wird.

17. Verwendung eines Zellhalters (10) gemäß einem der Ansprüche 1 bis 10 und / oder einer Aufnahmevorrichtung (100) gemäß einem der Ansprüche 11 bis 13 zur lösbaren Fixierung mindestens einer Batteriezelle (B), vorzugsweise während der Ausführung eines Testverfahrens an der Batteriezelle (B).
